# EUROPEAN PATENT SPECIFICATION

(11) **EP 0 732 430 B1**
(45) Date of publication and mention of the grant of the patent: **21.10.1998**
(21) Application number: 96301512.8
(22) Date of filing: 05.03.1996
(51) Int. Cl.: C30B 29/22, C30B 13/00

(54) **Manganese oxide-based single crystal having a laminar structure and method for the preparation thereof**
Einkristall auf Manganoxidbasis mit laminarer Struktur und Verfahren zu seiner Herstellung.
Monocristal à base d'oxyde de manganèse avec une structure laminaire et procédé pour sa préparation

(30) Priority: 16.03.1995 JP 57744/95
(43) Date of publication of application: 18.09.1996
(73) Proprietor: JAPAN as represented by DIRECTOR GENERAL OF AGENCY OF INDUSTRIAL SCIENCE AND TECHNOLOGY, Tokyo-to (JP); ANGSTROM TECHNOLOGY PARTNERSHIP, Tokyo-to (JP)
(72) Inventor: Moritomo, Yutaka, Ryugasaki-shi, Ibaraki-ken (JP); Asamitsu, Atsushi, Tsuchiura-shi, Ibaraki-ken (JP); Kuwahara, Hideki, Tsukuba-shi, Ibaraki-ken (JP); Tokura, Yoshinori, Fuchu-shi, Tokyo-to (JP)
(74) Representative: Baverstock, Michael George Douglas

(56) References cited:
- JOURNAL OF CRYSTAL GROWTH, vol. 84, no. 2, August 1987, AMSTERDAM NL, pages 207-211, XP002005875 HASHIMOTO ET AL.: "crystal growth and characterization of La1-xMxMnO3(M=Ca,Sr)"
- JAPANESE JOURNAL OF APPLIED PHYSICS, vol. 23, no. 9, September 1984, TOKYO JP, pages 1172-1175, XP002005876 MATSUURA ET AL: "single crystal growth of perovskite type La1-xSrxMO3 (M=Fe,Co) solid solution"
- JOURNAL OF CRYSTAL GROWTH, vol. 60, no. 1, November 1982, AMSTERDAM NL, pages 191-194, XP002005877 TANAKA ET AL.: "crystal growth of (La0.8Ca0.2)MnO3 by the TSFZ method"

## Description

### BACKGROUND OF THE INVENTION

The present invention relates to a novel manganese oxide-based single crystal having a laminar structure and a method for the preparation thereof. More particularly, the invention relates to a single crystal of lanthanum-strontium manganite having a laminar structure, which is useful as a material of a memory-switching type magnetic resistance element having greatly improved magnetic conductivity characteristics as well as a method for the preparation thereof.

It is a remarkable trend in recent years that, as an extension of the studies on the properties of copper oxide-based superconductors in a normal state, the interest has been rekindled for the spin charge-coupled dynamics closely correlated to the Mott transition in the systems of a 3d-electron transition metal oxide having strong electronic correlation. Among those substances having a metallic property and a strongly correlated 3d-electron system, several conductive ferromagnetics are known including, for example, those positive hole-doped manganese oxides having a crystalline structure of perovskite. The magnetic interaction therein is established by the inter-mediation of the so-called double-exchange interaction between the Mn³⁺ ions and Mn⁴⁺ ions. As to La_{0.69}Pb_{0.31}MnO₃ as one of the manganese oxide-based composite oxides belonging to this class, a large negative magnetic resistance is observed in the vicinity of the magnetic phase transition temperature. According to the results reported recently in Applied Physics Letters, volume 63, page 1990, Science, volume 264, page 413 and Physical Review Letters, volume 71, page 2331, thin films of (La,Ca)MnO₃ and (La,Ba)MnO₃ equally exhibit a negative magnetic resistance.

### SUMMARY OF THE INVENTION

The present invention accordingly has an object to provide a novel manganese oxide-based single-crystal material capable of exhibiting unique characteristics of magnetic conduction and having usefulness, for example, as an element of a memory-switching magnetic resistance device and a method for the preparation thereof.

Thus, the manganese oxide-based material provided by the present invention is a single crystal body having a laminar structure, of which the chemical composition is expressed by the general formula

(LaₓSr₁₋ₓ)_{y+1}Mn_{y}O_{3y+1}, (I)

in which the subscript x is a number in the range from 0.3 to 0.5 and the subscript y is a number of 1 or 2.

The above defined single crystal body having a laminar structure is prepared by a process which comprises the steps of:
(a) mixing together powders of oxides of lanthanum, strontium and manganese or compounds of lanthanum, strontium and manganese capable of being converted into the oxides of the respective elements by heating in a molar proportion corresponding to the formula

   (LaₓSr₁₋ₓ)_{y+1}Mn_{y}O_{3y+1}, (I)

   in which the subscript x is a number in the range from 0.3 to 0.5 and the subscript y is a number of 1 or 2, to give a powder blend;
(b) sintering the powder blend by heating at a temperature in the range from 1000 to 1400 °C in an oxygen-containing atmosphere to give a sintered mass;
(c) pulverizing the sintered mass into a powder;
(d) shaping the powder into a green body of the powder;
(e) sintering the green body of the powder by heating at a temperature in the range from 1100 to 1500 °C in an oxygen-containing atmosphere to give a sintered body; and
(f) subjecting the sintered body to a process of floating zone melting in an oxygen-containing atmosphere to effect crystallization into a single crystal.

### BRIEF DESCRIPTION OF THE DRAWING

Figures 1A, 1B and 1C are each a schematic illustration of the arrangement of the lanthanum and strontium atoms and the MnO₆ units in various types of manganese oxide-based single crystals including those of a single-layered structure, double-layered structure and infinite-layered structure, respectively.

Figure 2 is a powder X-ray diffractometric diagram of the inventive single crystal of a single-layered structure obtained in Example 1.

Figure 3 is a powder X-ray diffractometric diagram of the inventive single crystal of a double-layered structure obtained in Example 2.

Figure 4 is a powder X-ray diffractometric diagram of the single crystal of an infinite-layered structure obtained in Comparative Example 1.

Figure 5 is a graph showing the magnetization curves of the inventive single crystal obtained in Example 2 and the conventional single crystal obtained in Comparative Example 2.

Figure 6 is a graph showing the electric resistivity of the single crystals obtained in Example 2 and Comparative Example 2 within or in the absence of a magnetic field as a function of temperature.

Figure 7 is a graph showing the electric resistivity of the single crystals obtained in Example 2 and Comparative Example 2 at a temperature of 294K as a function of magnetic field.

### DETAILED DESCRIPTION OF THE PREFERRED EMBODIMENTS

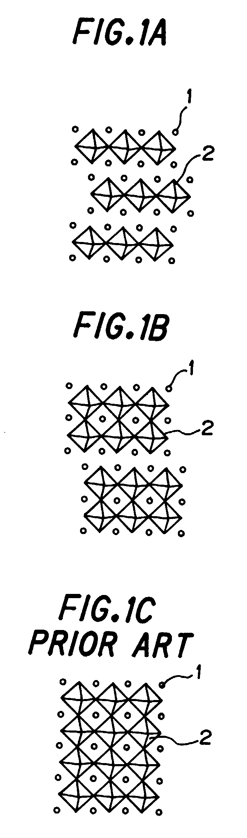

As is described above, the manganese oxide-based single crystal of the invention having a laminar structure has a chemical composition represented by the general formula

(LaₓSr₁₋ₓ)_{y+1}Mn_{y}O_{3y+1}, (I)

in which the subscript x is a number in the range from 0.3 to 0.5 and the subscript y is a number of 1 or 2. When the subscript y has a value of 1, the general formula (I) is converted into a formula

(LaₓSr₁₋ₓ)₂MnO₄, (II)

and the single crystal has a single-layered structure schematically illustrated in Figure 1A, in which each of the small circles 1 indicates an atom of lanthanum or strontium and each of the marks for octahedrons 2 indicates a MnO₆ unit. When the subscript y has a value of 2, the general formula (I) is converted into a formula

(LaₓSr₁₋ₓ)₃Mn₂O₇, (III)

and the single crystal has a double-layered structure schematically illustrated in Figure 1B, in which each of the small circles 1 and each of the marks for octahedrons 2 have the same meanings as mentioned above. These single-layered and double-layered laminar structures of the single crystal are unique as compared with the infinite-layered structure of a single crystal illustrated in Figure 1C, which corresponds to a perovskite structure known in the prior art having a chemical composition of (La,Sr)MnO₃.

It is an unexpected discovery that the inventive single crystal having a double-layered laminar structure has a greatly enhanced magnetic conductivity characteristic as compared with that having a single-layered structure. While a single crystal of the formula La_{0.6}Sr_{1.4}MnO₄ having a single-layered structure exhibits a conductivity characteristic similar to that of a semiconductor over the whole temperature range, for example, a single crystal of a double-layered structure having a chemical composition of La_{1.2}Sr_{1.8}Mn₂O₇ corresponding to the value x of 0.4 exhibits great changes in the electric resistivity measured in a magnetic field and magnetization below and above a critical temperature of around 126K. These phenomena suggest that the single crystal, which is an insulating material at elevated temperatures, is susceptible to a phase transition into a ferromagnetic metallic material at the critical temperature. The electric resistivity of the single crystal exhibits a great dependence not only on the temperature but also on the magnetic field. For example, the electric resistivity of the single crystal measured in a magnetic field of 1 T (tesla) is only about one hundredth of the value in the absence of magnetic field.

Though not fully clear, the above mentioned great changes in the magnetic conductivity characteristics can be understood in terms of following two mechanisms. Firstly, the localized spin interaction on the manganese atoms is imparted with anisotropy to cause an increase in the response of the spin to the magnetic field so that the movement of the conductive electrons can be energized with a relatively small magnetic field to alter the spin arrangement. Secondly, the synergistic effect of the localized spin arrangement and the movement of the conductive electrons cause a decrease in the electric resistivity to some extent which results in a transition into a ferromagnetic metallic state in an avalanche-like fashion. In this sense, the phenomenon of magnetic conductivity in this phase can be considered to be a transition between an insulating material and a ferromagnetic metal induced by the magnetic field.

The above defined single crystals of the invention having the unique laminar structure can be prepared by a process which comprises the steps of:
(a) mixing together powders of oxides of lanthanum, strontium and manganese or compounds of lanthanum, strontium and manganese capable of being converted into the oxides of the respective elements by heating in a molar proportion corresponding substantially to the formula

   (LaₓSr₁₋ₓ)_{y+1}Mn_{y}O_{3y+1}, (I)

   in which the subscript x is a number in the range from 0.3 to 0.5 and the subscript y is a number of 1 or 2, to give a powder blend;
(b) sintering the powder blend by heating at a temperature in the range from 1000 to 1400 °C in an oxygen-containing atmosphere to give a sintered mass;
(c) pulverizing the sintered mass into a powder;
(d) shaping the powder into a green body of the powder;
(e) sintering the green body of the powder by heating at a temperature in the range from 1100 to 1500 °C in an oxygen-containing atmosphere to give a sintered body; and
(f) subjecting the sintered body to a process of floating zone melting in an oxygen-containing atmosphere to effect crystallization into a single crystal.

In step (a) of the above described process, it is essential that the blending proportion of the lanthanum oxide and strontium oxide falls within the range that the subscript x in the general formula (I) is in the range from 0.3 to 0.5 since, if the blending proportion of these oxides is outside of this range, the desired single crystal having the unique laminar structure cannot be obtained even by undertaking the subsequent steps as described above. Further, the subscript y in the general formula (I), which is 1 or 2, should be satisfied, preferably, with a permissible error not exceeding ±1%.

The oxide powders of lanthanum, strontium and manganese suitable as the starting materials in step (a) include those expressed by the formulas La₂O₃, SrO and Mn₃O₄ although other kinds of manganese oxides can be used. The compounds of these elements convertible into the respective oxides by heating, either in an oxidizing atmosphere or in a non-oxidizing atmosphere, include carbonates such as lanthanum carbonate La₂(CO₃)₃, strontium carbonate SrCO₃ and manganese carbonate MnCO₃, hydrogencarbonates such as lanthanum hydrogencarbonate La(HCO₃)₃, strontium hydrogencarbonate Sr(HCO₃)₂ and manganese hydrogencarbonate Mn(HCO₃)₂ and the like, though not particularly limitative thereto. The powders as the starting materials can be blended in any known method including the dry and wet processes but the wet process is preferred in respect of the uniformity of the blend. For example, the powders are mixed together with addition of a small volume of a volatile solvent such as alcohols, ketones and the like having a relatively low boiling point followed by drying.

In the next place, the powder blend thus obtained is heated in air at a temperature of 1000 to 1400 °C for at least 10 hours to give a sintered mass which is then disintegrated or pulverized into a fine powder. If necessary, the cycle of sintering of the powder and disintegration of the sintered mass is repeated twice or more for completeness of the reaction of the metal oxides. The fine powder thus obtained is shaped by a suitable method such as compression molding into a green body of a desired form such as a cylinder either without or with use of a binder according to need and the green body is subjected to sintering by heating in air at a temperature in the range from 1100 to 1500 °C . Sintering of the green body is complete usually within 20 hours. The thus sintered body is finally subjected to the process of floating zone melting by using a seed crystal for the growth of a single crystal in an atmosphere of an oxidizing gas which is preferably oxygen gas pressurized to a superatmospheric pressure in order to ensure a high valency state of the manganese ions. The velocity of the crystal growing in the floating zone melting process is preferably in the range from 5 to 25 mm/hour.

The single crystalline body having a laminar structure is subjected to various analytical procedures for the determination of the chemical composition and the crystalline structure determined by the subscripts x and y in the formula (I) including X-ray powder diffractometry, X-ray diffraction Laue's photographic method, neutron diffraction, electron probe microanalysis, chemical analysis and so on.

The inventive single crystalline body of the composite oxide having a laminar structure exhibits a large temperature dependence of the electric resistivity and magnetization along with a magnetic field dependence of the electric resistivity so that the single crystalline body can be used as an element of a memory switching magnetic resistance device by utilizing this excellent magnetic conductivity behavior.

In the following, the present invention is described in more detail by way of examples.

### Example 1.

A single crystalline body of La_{0.6}Sr_{1.4}MnO₄ having a single-layered laminar structure was prepared in the following manner. Thus, 7.702 g of a powder of lanthanum oxide La₂O₃, 16.287 g of a powder of strontium carbonate SrCO₃ and 6.010 g of a powder of manganese oxide Mn₃O₄ were mixed together to correspond to the formula La_{0.6}Sr_{1.4}MnO₄ with addition of a small volume of ethyl alcohol for 30 minutes in a ball mill. After drying by evaporating the ethyl alcohol, the powder blend was calcined in air at 1250 °C for 24 hours to give a sintered mass and the mass was finely disintegrated into a powder which was again subjected to calcination in air at 1250 °C for 24 hours and disintegration into a fine powder.

The thus obtained oxide powder was shaped by compression molding under a molding pressure of 2 tons/cm² into a cylindrical green body having a diameter of 6 mm and a length of 80 mm which was subjected to sintering in air at 1350 °C for 48 hours.

The sintered rod was subjected to the process of floating zone melting in a furnace equipped with two halogen sun lamps and semi-elliptic focusing mirrors in an atmosphere of oxygen gas pressurized to 2 atmospheres. The sintered rod and the seed crystal were rotated in the reverse directions at a relative velocity of 30 rpm and a single crystal was grown at a rate of 10 to 20 mm/hour.

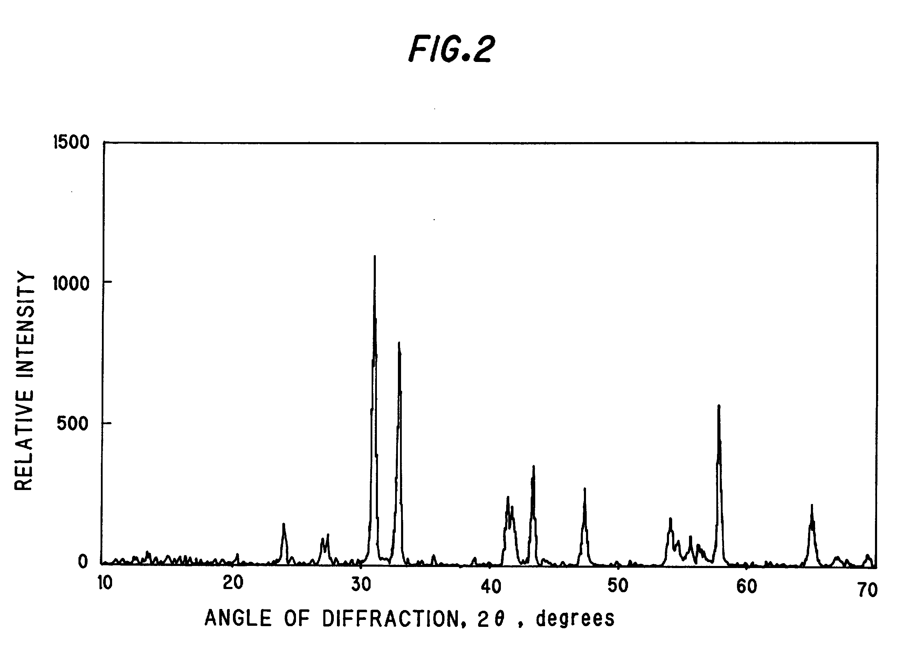

As confirmed by the Laue's photographic method, the thus obtained product had a structure of single crystal and had a single-layered laminar structure according to the results of the powder X-ray diffractometry which indicated that this crystal belonged to the tetragonal crystal system with a = b = 0.386 nm and c = 1.249 nm. Chemical analysis of the crystal for the contents of lanthanum, strontium and manganese gave a result that the chemical composition of the crystal was identical with the formulation of the starting powder mixture. A diagram obtained in the powder X-ray diffractometry of the product, carried out with CuKα , is shown in Figure 2.

### Example 2.

A single crystalline body of La_{1.2}Sr_{1.8}Mn₂O₇ having a double-layered laminar structure was prepared in the following manner. Thus, 9.555 g of a powder of lanthanum oxide La₂O₃, 12.989 g of a powder of strontium carbonate SrCO₃ and 9.456 g of a powder of manganese oxide Mn₃O₄ were mixed together to correspond to the formula La_{1.2}Sr_{1.8}Mn₂O₇ with addition of a small volume of ethyl alcohol for 30 minutes in a ball mill. After drying by evaporating the ethyl alcohol, the powder blend was calcined in air at 1350 °C for 24 hours to give a sintered mass and the mass was finely disintegrated into a powder which was again subjected to calcination in air at 1350 °C for 24 hours and disintegration into a fine powder.

The thus obtained oxide powder was shaped by compression molding under a molding pressure of 2 tons/cm² into a cylindrical green body having a diameter of 6 mm and a length of 80 mm which was subjected to sintering in air at 1400 °C for 48 hours.

The sintered rod was subjected to the process of floating zone melting in a furnace equipped with two halogen sun lamps and semi-elliptic focusing mirrors in an atmosphere of oxygen gas pressurized to 2 atmospheres. The sintered rod and the seed crystal were rotated in the reverse directions at a relative velocity of 30 rpm and a single crystal was grown at a rate of 10 to 20 mm/hour.

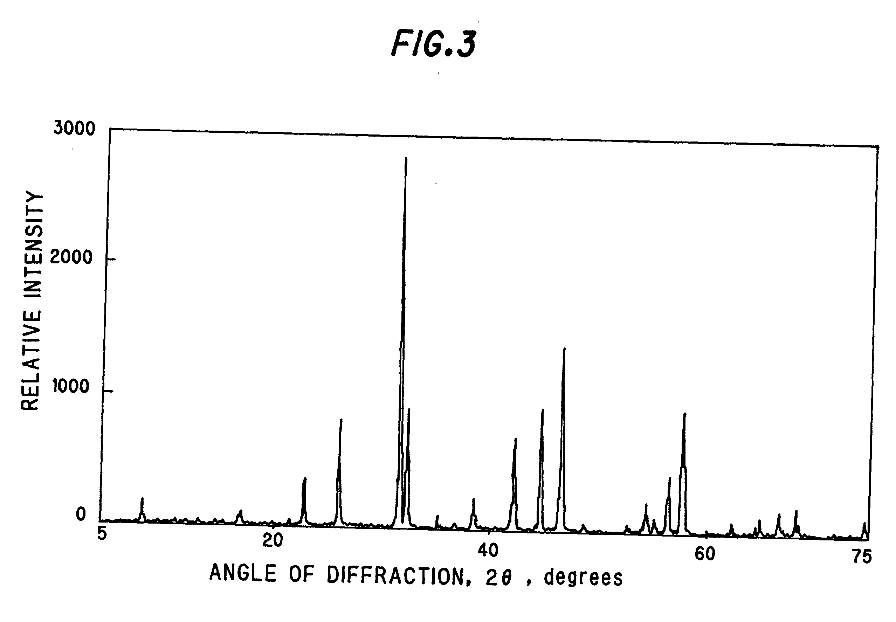

As confirmed by the Laue's photographic method, the thus obtained product had a structure of single crystal and had a double-layered laminar structure according to the results of the powder X-ray diffractometry to give the X-ray diffractometric diagram shown in Figure 3 which indicated that this crystal belonged to the tetragonal crystal system with a = b = 0.388 nm and c = 2.114 nm. Chemical analysis of the crystal for the contents of lanthanum, strontium and manganese gave a result that the chemical composition of the crystal was identical with the formulation of the starting powder mixture.

### Comparative Example 1.

A single crystalline body of La_{0.6}Sr_{0.4}MnO₃ having a perovskite structure was prepared in the following manner. Thus, a powder of lanthanum oxide La₂O₃, powder of strontium carbonate SrCO₃ and powder of manganese oxide Mn₃O₄ were mixed together in such a proportion that the atomic ratio of Mn:La:Sr was 1:0.6:0.4 to correspond to the formula La_{0.6}Sr_{0.4}MnO₃ with addition of a small volume of acetone for 1 hour in a ball mill. After drying by evaporating the acetone, the powder blend was calcined in air at 1200 °C for 24 hours to give a sintered mass which was disintegrated into a fine powder.

The thus obtained oxide powder was shaped by compression molding under a molding pressure of 2 tons/cm² into a cylindrical green body having a diameter of 5 mm and a length of 80 mm which was subjected to sintering in air at 1200 °C for 12 hours.

The sintered rod was subjected to the process of floating zone melting in a furnace equipped with two halogen sun lamps and semi-elliptic focusing mirrors in an atmosphere of air. The sintered rod and the seed crystal were rotated in the reverse directions at a relative velocity of 30 rpm and a single crystal was grown at a rate of 8 to 10 mm/hour.

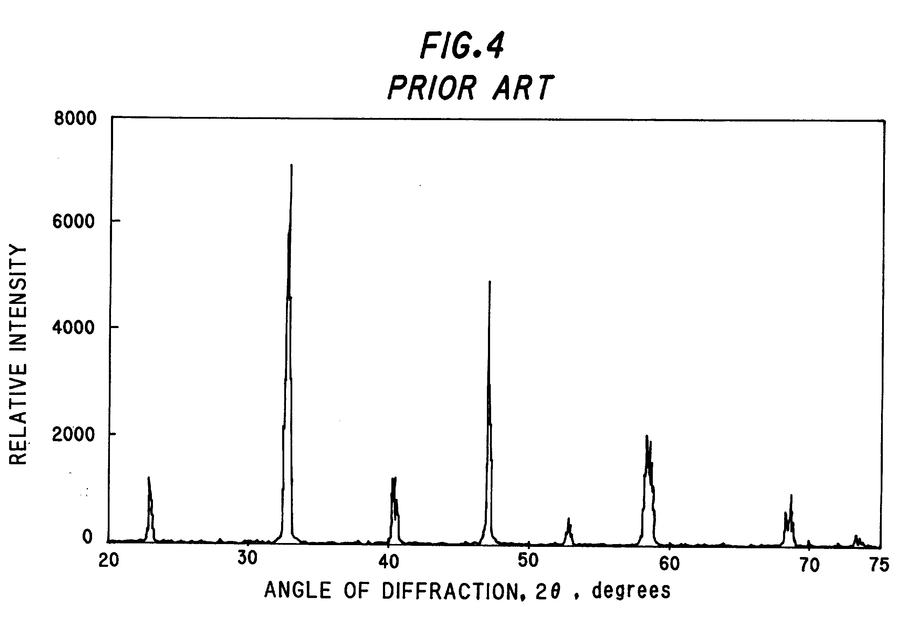

As confirmed by the Laue's photographic method, the thus obtained product had a structure of single crystal and had an infinite-layered perovskite structure according to the results of the powder X-ray diffractometry to give the X-ray diffractometric diagram shown in Figure 4 which indicated that this crystal belonged to the rhombohedral crystal system with a = 0.546 nm and α = 60.05°. Chemical analysis of the crystal for the contents of lanthanum, strontium and manganese gave a result that the chemical composition of the crystal was identical with the formulation of the starting powder mixture.

### Comparative Example 2.

A single crystalline body of La_{0.825}Sr_{0.175}MnO₃ having a perovskite structure belonging to the orthorhombic crystal system was prepared in substantially the same manner as in Comparative Example 1 excepting modification of the weight proportion of the oxide and carbonate powders in the starting powder blend to be in conformity with the above given composition formula.

### Reference Example 1.

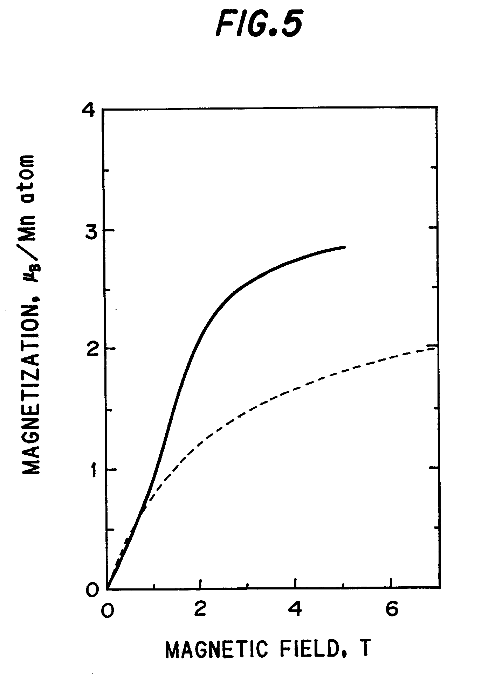

The single crystal having a double-layered laminar structure of La_{1.2}Sr_{1.8}Mn₂O₇ prepared in Example 2 was subjected to the measurement of the magnetization curve at a temperature of 140K, higher by 10K than the ferromagnetic transition temperature Tc, in a magnetic field of up to 5 T to give the result shown by the solid line curve in Figure 5, in which the magnetization is given by µ_{B} per manganese atom.

Similarly, the perovskite single crystal of La_{0.825}Sr_{0.175}MnO₃ prepared in Comparative Example 2 was subjected to the measurement of the magnetization curve at a temperature of 294K, higher by 10K than the ferromagnetic transition temperature Tc, in a magnetic field of up to 7 T to give the result shown by the broken line curve in Figure 5.

As is understood from Figure 5, magnetization of the single crystal of the double-layered laminar structure according to the invention is much easier than the perovskite single crystal.

### Reference Example 2.

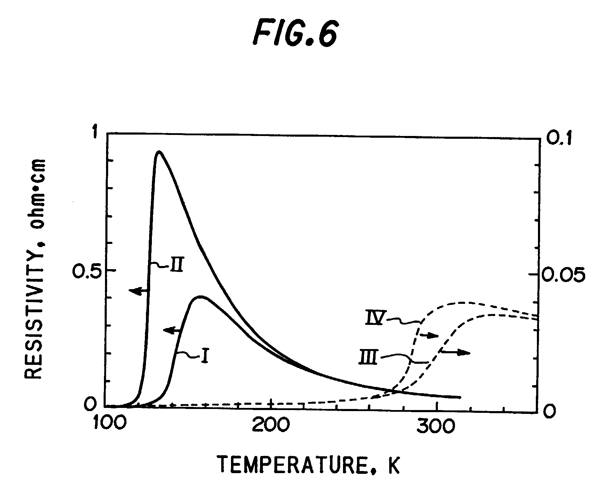

The single crystal having a double-layered laminar structure of La_{1.2}Sr_{1.8}Mn₂O₇ prepared in Example 2 was subjected to the measurement of the electric resistivity at varied temperatures in the range from 100K to 350K in a magnetic field of 2 T and in the absence of magnetic field to give the result shown by the curves I and II, respectively, in Figure 6.

Similarly, the perovskite single crystal of the formula La_{0.825}Sr_{0.175}MnO₃ prepared in Comparative Example 2 was subjected to the measurement of the electric resistivity at varied temperatures in the range from 100K to 350K in a magnetic field of 2 T and in the absence of magnetic field to give the result shown by the curves III and IV, respectively, in Figure 6.

### Reference Example 3.

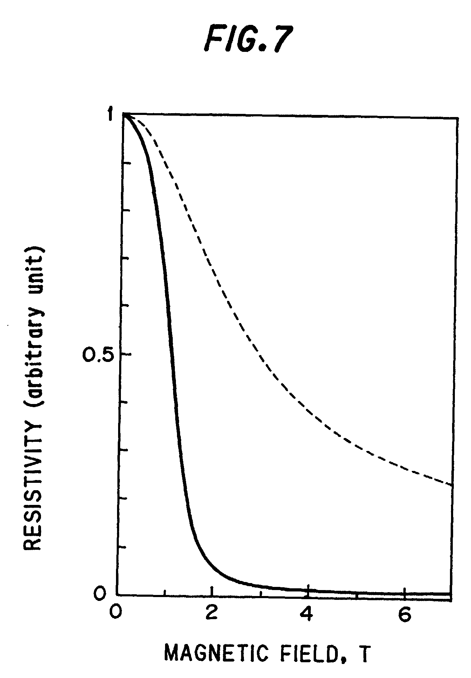

The single crystal having a double-layered laminar structure of La_{1.2}Sr_{1.8}Mn₂O₇ prepared in Example 2 was subjected to the measurement of the electric resistivity under varied magnetic fields up to 7 T at a temperature of 140K to give the result shown by the solid line curve in Figure 7.

Similarly, the perovskite single crystal of the formula La_{0.825}Sr_{0.175}MnO₃ prepared in Comparative Example 2 was subjected to the measurement of the electric resistivity under varied magnetic fields up to 7 T at a temperature of 294K to give the result shown by the broken line curve in Figure 7.

As is understood from Figure 7, the electric resistivity of the single crystal of the double-layered laminar structure according to the invention is much more sensitive to the changes in the magnetic field than the perovskite single crystal.

## Claims

1. A single crystal body having a laminar structure, of which the chemical composition is expressed by the general formula
(LaₓSr₁₋ₓ)_{y+1}Mn_{y}O_{3y+1},
in which the subscript x is a number in the range from 0.3 to 0.5 and the subscript y is a number equal to 1 or 2, with a permissible error not exceeding ± 1%.

2. A method for the preparation of a single crystal body having a laminar structure, of which the chemical composition is expressed by the general formula
(LaₓSr₁₋ₓ)_{y+1}Mn_{y}O_{3y+1},
in which the subscript x is a number in the range from 0.3 to 0.5 and the subscript y is a number equal to 1 or 2, with a permissible error not exceeding ± 1% which comprises the steps of:
(a) mixing together powders of oxides of lanthanum, strontium and manganese or compounds of lanthanum, strontium and manganese capable of being converted into the oxides of the respective elements by heating in a molar proportion corresponding to the formula
(LaₓSr₁₋ₓ)_{y+1}Mn_{y}O_{3y+1},
in which each of the subscripts x and y has the same meaning as defined above, to give a powder blend;
(b) sintering the powder blend by heating at a temperature in the range from 1000 to 1400 °C in an oxygen-containing atmosphere to give a sintered mass;
(c) pulverizing the sintered mass into a powder;
(d) shaping the powder into a green body of the powder;
(e) sintering the green body of the powder by heating at a temperature in the range from 1100 to 1500 °C in an oxygen-containing atmosphere to give a sintered body; and
(f) subjecting the sintered body to a process of floating zone melting in an oxygen-containing atmosphere to effect crystallization into a single crystal.

3. The method as claimed in claim 2 in which the oxygen-containing atmosphere in step (f) is an atmosphere of oxygen gas.

4. The method as claimed in claim 3 in which the atmosphere of oxygen gas is pressurized to a pressure of at least 2 atmospheres.

5. The method as claimed in claim 2 in which the rate of crystallization in the process of floating zone melting is in the range from 5 mm to 25 mm per hour.

6. Use of a single crystal body as claimed in claim 1 or when prepared by the method claimed in any one of claims 2 to 5 in a memory-switching type magnetic resistance element.

## Patentansprüche

1. Einkristallkörper mit laminarer Struktur, dessen chemische Zusammensetzung durch die allgemeine Formel
(LaₓSr₁₋ₓ)_{y+1}Mn_{y}O_{3y+1},
in der der tiefgestellte Index x eine Zahl im Bereich von 0,3 bis 0,5 und der tiefgestellte Index y die Zahl 1 oder 2 ist, wobei der erlaubte Fehler ± 1 % nicht übersteigt, dargestellt wird.

2. Verfahren zur Herstellung eines Einkristallkörpers mit laminarer Struktur, dessen chemische Zusammensetzung durch die allgemeine Formel
(LaₓSr₁₋ₓ)_{y+1}Mn_{y}O_{3y+1},
in der der tiefgestellte Index x eine Zahl im Bereich von 0,3 bis 0,5 und der tiefgestellte Index y die Zahl 1 oder 2 ist, wobei der erlaubte Fehler ± 1 % nicht übersteigt, dargestellt wird, bei dem:
(a) Pulver von Oxiden von Lanthan, Strontium und Mangan oder von Verbindungen von Lanthan, Strontium und Mangan, die durch Erhitzen in einem der Formel
(LaₓSr₁₋ₓ)_{y+1}Mn_{y}O_{3y+1},
in der die tiefgestellten Indices x und y die oben angegebenen Bedeutungen haben, entsprechenden Molverhältnis in die Oxide der entsprechenden Elemente umgewandelt werden können, vermischt werden, so daß sich ein Pulvergemisch ergibt,
(b) das Pulvergemisch durch Erhitzen auf eine Temperatur im Bereich von 1000 bis 1400°C in einer sauerstoffhaltigen Atmosphäre unter Erhalt einer Sintermasse gesintert wird,
(c) die Sintermasse zu einem Pulver pulverisiert wird,
(d) das Pulver zu einem Vorpreßling aus dem Pulver geformt wird,
(e) der Vorpreßling aus dem Pulver durch Erhitzen auf eine Temperatur im Bereich von 1100 bis 1500°C in einer sauerstoffhaltigen Atmosphäre unter Erhalt eines Sinterkörpers gesintert wird und
(f) der Sinterkörper einem Verfahren zum tiegellosen Zonenschmelzen in einer sauerstoffhaltigen Atmosphäre zur Kristallisation in Form eines Einkristalls unterzogen wird.

3. Verfahren nach Anspruch 2, wobei die sauerstoffhaltige Atmosphäre in Schritt (f) eine Atmosphäre aus Sauerstoffgas ist.

4. Verfahren nach Anspruch 3, wobei die Atmosphäre aus Sauerstoffgas unter einem Druck von mindestens 2 Atmosphären steht.

5. Verfahren nach Anspruch 2, wobei die Kristallisationsgeschwindigkeit in dem Verfahren zum tiegelfreien Zonenschmelzen im Bereich von 5 mm bis 25 mm/h liegt.

6. Verwendung eines Einkristallkörpers nach Anspruch 1, oder wenn dieser nach dem Verfahren nach einem der Ansprüche 2 bis 5 hergestellt worden ist, in einem Magnetwiderstandelement vom Speicherschalttyp.

## Revendications

1. Corps monocristallin ayant une structure laminaire, dont la composition chimique est exprimée par la formule générale
(LaₓSr₁₋ₓ)_{y+1}Mn_{y}0_{3y+1},
dans laquelle l'indice x est un nombre dans l'intervalle de 0,3 à 0,5 et l'indice y est un nombre égal à 1 ou 2, avec une erreur autorisable n'excédant pas ± 1%.

2. Méthode pour la préparation d'un corps monocristallin ayant une structure laminaire, dont la composition chimique est exprimée par la formule générale
(LaₓSr₁₋ₓ)_{y+1}Mn_{y}0_{3y+1},
dans laquelle l'indice x est un nombre dans l'intervalle de 0,3 à 0,5 et l'indice y est un nombre égal à 1 ou 2, avec une erreur autorisable n'excédant pas ± 1% qui comprend les étapes de :
(a) mélange ensemble de poudres d'oxydes de lanthane, de strontium et manganèse ou de composés de lanthane, de strontium et de manganèse capable d'être convertis en des oxydes des éléments respectifs par chauffage en une proportion molaire correspondant à la formule
(LaₓSr₁₋ₓ)_{y+1}Mn_{y}0_{3y+1},
dans laquelle chacun des indices x et y a la même signification que définie ci-dessus, pour donner un mélange de poudre ;
(b) frittage du mélange de poudre par chauffage à une température dans l'intervalle de 1000 à 1400 °C dans une atmosphère contenant de l'oxygène pour donner une masse frittée ;
(c) pulvérisation de la masse frittée en une poudre ;
(d) mise en forme de la poudre en un corps cru de la poudre ;
(e) frittage du corps cru de la poudre par chauffage à une température dans l'intervalle de 1100 à 1500 °C dans une atmosphère contenant de l'oxygène pour donner un corps fritté ; et
(f) soumission du corps fritté à un procédé de fusion à zone de flottation dans une atmosphère contenant de l'oxygène pour effectuer une cristallisation en un monocristal.

3. Méthode selon la revendication 2, dans laquelle l'atmosphère contenant de l'oxygène de l'étape (f) est une atmosphère de gaz oxygène.

4. Méthode selon la revendication 3, dans laquelle l'atmosphère de gaz oxygène est comprimée à une pression d'au moins 2 atmosphères.

5. Méthode selon la revendication 2, dans laquelle la vitesse de cristallisation dans le procédé de fusion à zone de flottation est dans l'intervalle de 5 mm à 25 mm par heure.

6. Utilisation d'un corps monocristallin selon la revendication 1, ou préparé par la méthode selon l'une quelconque des revendications 2 à 5 dans un élément de résistance magnétique du type à commutation de mémoire.
